# EUROPEAN PATENT SPECIFICATION

(11) **EP 4 495 713 B1**
(45) Date of publication and mention of the grant of the patent: **06.05.2026**
(21) Application number: 23794224.8
(22) Date of filing: 16.10.2023
(51) Int. Cl.: H03K 17/18, H03K 17/00, G05B 9/03

(54) **DYNAMIC COLLECTION CIRCUIT AND TRANSPONDER TRANSMISSION SYSTEM**
DYNAMISCHE SAMMELSCHALTUNG UND TRANSPONDERÜBERTRAGUNGSSYSTEM
CIRCUIT DE COLLECTE DYNAMIQUE ET SYSTÈME DE TRANSMISSION DE TRANSPONDEUR

(30) Priority: 31.05.2023 CN 202310627420
(43) Date of publication of application: 22.01.2025
(73) Proprietor: CRSC RESEARCH & DESIGN INSTITUTE GROUP CO., LTD., Fengtai District Beijing 100070 (CN)
(72) Inventor: LI, Qun, Beijing 100070 (CN); CHEN, Guang, Beijing 100070 (CN); CHENG, Bangfeng, Beijing 100070 (CN)
(74) Representative: Haseltine Lake Kempner LLP
(86) International application number: PCT/CN2023/124767
(87) International publication number: WO 2024/244258

(56) References cited:
- CN-A- 101 908 885
- CN-A- 102 692 604
- CN-A- 105 824 273
- CN-A- 105 824 273
- CN-A- 116 360 245
- CN-U- 214 451 017
- CN-U- 214 451 017
- US-A- 5 357 425
- US-A1- 2014 250 469

## Description

### TECHNICAL FIELD

The present invention relates to the technical field of signal acquisition, and in particular, to a dynamic acquisition circuit and transponder transmission system.

### BACKGROUND

In the operation of rail traffic, the safety and reliability of the system is extremely important, especially with the rapid development of high-speed railway, the reliability of signal equipment will directly affect the safety of rail traffic, so the safety and reliability control of signal equipment is of great importance.

In rail traffic, the state of signal can be judged by acquisition the contact state of relay, so as to ensure safe driving. There is only one control terminal in the existing acquisition circuit. When the processor or the controller that inputs the control signal fails, the output electrical signal according to the signal of the control terminal will lead to wrong state judgment, which will not guarantee the safety of the rail traffic system. Therefore, how to improve the accuracy of contact signal acquisition has become an urgent technical problem to be solved.

Prior art documents related to the present invention are CN105824273A and CN214451017U.

### SUMMARY

The present invention provides a dynamic acquisition circuit and a transponder transmission system to improve the accuracy of the sampling signal output by the dynamic acquisition circuit.

In a first aspect, the present invention provides a dynamic acquisition circuit comprising:
a plurality of sampling terminals in corresponding electrical connection with a plurality of contacts of an external relay, wherein the sampling terminal is used for receiving a contact signal of the external relay;
a first controller and a second controller, wherein the first controller comprises a plurality of first output terminals and a plurality of first receiving terminals, the first output terminal is used for outputting a first control signal, the second controller comprises a plurality of second output terminals, a plurality of third output terminals, and a plurality of second receiving terminals, the second output terminal is used for outputting a second control signal, and the third output terminal is used for outputting a third control signal;
a plurality of acquisition circuits, wherein a positive input terminal of each of the acquisition circuits being electrically connected with each of the sampling terminals in one-to-one correspondence respectively, a negative input terminal of each of the acquisition circuits being grounded, a first control terminal of each of the acquisition circuits being electrically connected with each of the first output terminals in one-to-one correspondence respectively, a second control terminal of each of the acquisition circuits being electrically connected with each of the second output terminals in one-to-one correspondence respectively, a third control terminal of each of the acquisition circuits being electrically connected with each of the third output terminals in one-to-one correspondence respectively, a sampling output terminal of each of the acquisition circuits being electrically connected with each of the first receiving terminals in one-to-one correspondence respectively, a sampling output terminals of each of the acquisition circuits being also electrically connected with each of the second receiving terminals in one-to-one correspondence respectively; the acquisition circuit is used for providing a sampling signal to the first controller and the second controller, respectively, according to the contact signal, the first control signal, the second control signal, and the third control signal.

Optionally, the acquisition circuit comprises an acquisition pulse logic circuit and a photoelectric isolation sampling circuit;
the acquisition pulse logic circuit comprises a control output terminal, the first control terminal, the second control terminal and the third control terminal; the control output terminal is electrically connected with a sampling control terminal; the first control terminal is electrically connected with the first output terminal, the second control terminal is electrically connected with the second output terminal, and the third control terminal is electrically connected with the third output terminal; the acquisition pulse logic circuit is used for outputting a sampling control signal to the photoelectric isolation sampling circuit according to the first control signal, the second control signal, and the third control signal;
the photoelectric isolation sampling circuit comprises the sampling control terminal, the positive input terminal, the negative input terminal, and the sampling output terminal; the sampling control terminal is electrically connected with the control output terminal; the positive input terminal is electrically connected with the sampling terminal; the sampling output terminal is electrically connected with the first receiving terminal and the second receiving terminal respectively; the photoelectric isolation sampling circuit is used for outputting the sampling signal to the first controller and the second controller according to the sampling control signal and the contact signal of the external relay acquired at the acquisition terminal.

Optionally, the acquisition pulse logic circuit further comprises an XOR gate, an AND gate, and a first resistance;
a first terminal of the XOR gate is electrically connected with the second control terminal; a second terminal of the XOR gate is electrically connected with the third control terminal through the first resistance;
a first terminal of the AND gate is electrically connected with the first control terminal; a second terminal of the AND gate is electrically connected with an output terminal of the XOR gate, and an output terminal of the AND gate is electrically connected with the control output terminal.

Optionally, the photoelectric isolation sampling circuit further comprises a threshold circuit, an optocoupler control circuit, an optocoupler acquisition circuit;
an input terminal of the threshold circuit is electrically connected with the positive input terminal, and an output terminal of the threshold circuit is electrically connected with a first terminal of the optocoupler acquisition circuit; the threshold circuit is used for providing a first electrical signal to the optocoupler acquisition circuit according to the contact signal;
an input terminal of the optocoupler control circuit is electrically connected with the sampling control terminal, and an output terminal of the optocoupler control circuit is electrically connected with a second terminal of the optocoupler acquisition circuit; the optocoupler control circuit is used for providing a second electrical signal to the optocoupler acquisition circuit according to the sampling control signal;
an output terminal of the optocoupler acquisition circuit is electrically connected with the sampling output terminal; the optocoupler acquisition circuit is used for outputting the sampling signal according to the first electrical signal and the second electrical signal.

Optionally, the optocoupler control circuit comprises a first optocoupler switch and a second resistance;

The first photocoupling switch comprises a first photosensitive element and a first light-emitting diode;
the first optocoupler switch comprises a first photosensitive element and a first light emitting diode;
a first terminal of the second resistance is electrically connected with a power supply, a second terminal of the second resistance is electrically connected with an anode of the first light emitting diode, a cathode of the first light emitting diode is electrically connected with the sampling control terminal;
a first terminal of the first photosensitive element is electrically connected with the second terminal of the optocoupler acquisition circuit, and the second terminal of the first photosensitive element is grounded.

Optionally, the optocoupler acquisition circuit comprises a second optocoupler switch and a third resistance;
the second optocoupler switch comprises a second photosensitive element and a second light emitting diode;
an anode of the second light emitting diode is electrically connected with the first terminal of the optocoupler acquisition circuit, a cathode of the second light emitting diode is electrically connected with the second terminal of the optocoupler acquisition circuit;
a first terminal of the second photosensitive element is electrically connected with a power supply, a second terminal of the second photosensitive element is electrically connected with a ground terminal, an output terminal of the second photosensitive element is electrically connected with the sampling output terminal;
a first terminal of the third resistance is electrically connected with the power supply, and a second terminal of the third resistance is coupled to an output terminal of the second photosensitive element.

Optionally, the threshold circuit comprises a transient suppression diode;
an anode of the transient suppression diode is electrically connected with the first terminal of the optocoupler acquisition circuit, and a cathode of the transient suppression diode is electrically connected with the positive input terminal.

Optionally, the photoelectric isolation sampling circuit further comprises a protection circuit;
a first terminal of the protection circuit is electrically connected with the positive input terminal, and a second terminal of the protection circuit is electrically connected with the negative input terminal.

In a second aspect, the present invention provides a transponder transmission system comprising: a processing board, an output board, a transponder, and the dynamic acquisition circuit of the first aspect: the processing board comprising a first processor and a second processor;
the first processor is connected with the first controller in the dynamic acquisition circuit; the first processor is used for providing sampling command information to the first controller, receiving sampling information fed back by the first controller, and selecting an output message according to the sampling information fed back by the first controller;
the second processor is connected with the second controller in the dynamic acquisition circuit; the second processor is used for providing sampling command information to the second controller, receiving sampling information fed back by the second controller, and selecting an output message according to the sampling information fed back by the second controller;
the output board is electrically connected with the processing board and the transponder, respectively; the output board is used for providing, after encoding the message output by the processing board, the encoded message to the transponder;
the transponder is used for outputting an electromagnetic signal according to the input encoded information.

Optionally, the output board is further used for feeding back the output message to the processing board as a feedback message;
the processing board is further used for comparing the feedback message with the output message, and determining a current message output status of the output board according to the comparison.

Optionally, further comprising: a monitoring module; the monitoring module is electrically connected with the dynamic acquisition circuit, the processing board and the output board respectively; the monitoring module is used for recording running status information of the dynamic acquisition circuit, the processing board and the output board.

According to the technical solution provided by the present invention, by electrically connecting the positive input terminals of the plurality of acquisition circuits with the plurality of sampling terminals in one-to-one correspondence, the negative input terminal of each of acquisition circuits being grounded, the first control terminal of each of acquisition circuits receiving the first control signal outputted by the first controller, the second control terminal receiving the second control signal outputted by the second controller, and the third control terminal receiving the third control signal outputted by the second controller, the acquisition circuit outputs a sampling signal on contact signals of the external relay according to the contact signal, the first control signal, the second control signal and the third control signal, preventing failure of either the first controller or the second controller to result in output of an erroneous sampling signal, improving the accuracy of the sampling signal output by the dynamic acquisition circuit, thereby improving the safety of the rail traffic system.

### BRIEF DESCRIPTION OF DRAWINGS

In order to more clearly illustrate the technical solution in the embodiments of the present invention, the drawings required for use in the description of the embodiments will be briefly described below.
FIG. 1 is a structural schematic diagram of a dynamic acquisition circuit provided by the embodiment of the present invention;
FIG. 2 is a structural schematic diagram of an acquisition circuit provided by the embodiment of the present invention;
FIG. 3 is a circuit schematic diagram of an acquisition pulse logic circuit provided by the embodiment of the present invention;
FIG. 4 is a structural schematic diagram of a photoelectric isolation sampling circuit provided by the embodiment of the present invention;
FIG. 5 is a circuit schematic diagram of a photoelectric isolation sampling circuit provided by the embodiment of the present invention;
FIG. 6 is a circuit schematic diagram of another photoelectric isolation sampling circuit provided by the embodiment of the present invention;
FIG. 7 is a circuit schematic diagram of yet another photoelectric isolation sampling circuit provided by the embodiment of the present invention;
FIG. 8 is a structural schematic diagram of a transponder transmission system provided by the embodiment of the present invention;
FIG. 9 is a structural schematic diagram of another transponder transmission system provided by the embodiment of the present invention;
FIG. 10 is a structural schematic diagram of yet another transponder transmission system provided by the embodiment of the present invention.

### DETAILED DESCRIPTION

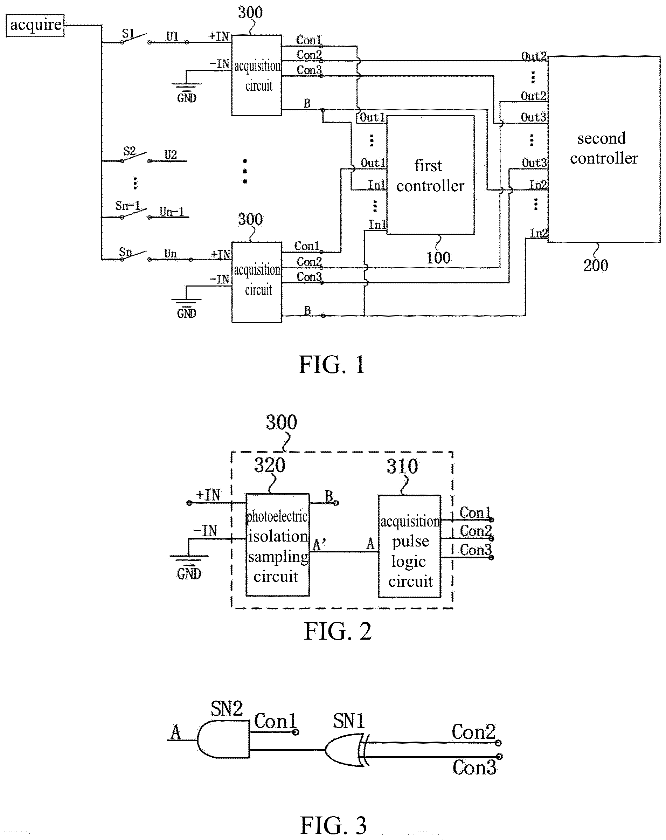

FIG. 1 is a structural schematic diagram of a dynamic acquisition circuit provided by an embodiment of the present invention, and as shown in FIG. 1, the dynamic acquisition circuit 900 comprises: a plurality of sampling terminals U1, U2,..., Un in corresponding electrical connection with a plurality of contacts S1, S2,..., Sn of an external relay; the sampling terminal U is used for receiving a contact signal of the external relay. A first controller 100 and a second controller 200; the first controller 100 comprises a plurality of first output terminals Out1 and a plurality of first receiving terminals In1; the first output terminal Out1 is used for outputting a first control signal; the second controller 200 comprises a plurality of second output terminals Out2, a plurality of third output terminals Out3, and a plurality of second receiving terminals In2; the second output terminal Out2 is used for outputting a second control signal; the third output terminal Out3 is used for outputting a third control signal. A plurality of acquisition circuits 300, a positive input terminal +IN of each of the acquisition circuits 300 being electrically connected with each of the sampling terminals U1, U2,..., Un in one-to-one correspondence respectively, a negative input terminal -IN of each of the acquisition circuits 300 being grounded, a first control terminal Con1 of each of the acquisition circuits 300 being electrically connected with each of the first output terminals Out1 in one-to-one correspondence respectively, a second control terminal Con2 of each of the acquisition circuits 300 being electrically connected with each of the second output terminals Out2 in one-to-one correspondence respectively, a third control terminal Con3 of each of the acquisition circuits 300 being electrically connected with each of the third output terminals Out3 in one-to-one correspondence respectively, a sampling output terminal B of each of the acquisition circuits 300 being electrically connected with each of the first receiving terminals In1 in one-to-one correspondence respectively, a sampling output terminals B of each of the acquisition circuits 300 being also electrically connected with each of the second receiving terminals In2 in one-to-one correspondence respectively; the acquisition circuit 300 is used for providing a sampling signal to the first controller 100 and the second controller 200, respectively, according to the contact signal, the first control signal, the second control signal, and the third control signal.

Among them, the contact signal of the relay comprises the voltage signal when the contact is opened or closed, and so on. The first controller 100 and the second controller 200 may include an FPGA (Field Programmable Gate Array) or the like.

It will be understood that the plurality of sampling terminals are electrically connected corresponding to the plurality of contacts of the external relay, i.e. the number of sampling terminals may be the same as or different from the number of contacts of the external relay. Taking the same number of sampling terminals as the number of contacts of the external relay as an example, in an exemplary embodiment, both the number of sampling terminals and the number of contacts of the external relay may be 16. Correspondingly, the positive input terminal of each of acquisition circuits is electrically connected with each of sampling terminals in one-to-one correspondence respectively, so the number of acquisition circuits is equal to the number of sampling terminals. At this time, when the number of sampling terminals is 16, the number of acquisition circuits is also 16.

Specifically, taking the acquisition circuit 300 electrically connected with the sampling terminal U1 as an example, the positive input terminal +IN of the acquisition circuit 300 is used for receiving the contact signal of the relay, the negative input terminal -IN is grounded, and at the same time, the first output terminal Out1 of the first controller 100 outputs the first control signal to the first control terminal Con1 of the acquisition circuit 300, the second output terminal Out2 of the second controller 200 outputs the second control signal to the second control terminal Con2 of the acquisition circuit 300, the third output terminal Out3 of the second controller 200 outputs the third control signal to the third control terminal Con3 of the acquisition circuit 300, and the acquisition circuit 300 internally performs circuit logic transformation according to the input contact signal, the input first control signal, the input second control signal and the input third control signal, and outputs a sampling signal to the first controller 100 and the second controller 200 so that the first controller 100 and the second controller 200 output corresponding dynamic codes according to the sampling signal; wherein the dynamic code may be 32-bit data or the like including information such as a time stamp and number of acquisition circuit; the first controller 100 and the second controller 200 transmit the sampling signal to a subsequent processor or the like in a serial communication manner so that the subsequent processor selects an output message or the like according to the sampling signal.

It will be appreciated that the first control signal, the second control signal, and the third control signal may be a high level or low level, may be analog signal or digital signal, and in an alternative embodiment, the first control signal, the second control signal, and the third control signal may be 32-bit binary dynamic codes.

The embodiment of the present invention provides a dynamic acquisition circuit. By electrically connecting the positive input terminals of the plurality of acquisition circuits with the plurality of sampling terminals in one-to-one correspondence, the negative input terminal of each of acquisition circuits being grounded, the first control terminal of each of acquisition circuits receiving the first control signal outputted by the first controller, the second control terminal receiving the second control signal outputted by the second controller, and the third control terminal receiving the third control signal outputted by the second controller, the acquisition circuit can output a sampling signal on contact signals of the external relay according to the contact signal, the first control signal, the second control signal and the third control signal, preventing failure of either the first controller or the second controller to result in output of an erroneous sampling signal, improving the accuracy of the sampling signal output by the dynamic acquisition circuit, thereby improving the safety of the rail traffic system.

Alternatively, FIG. 2 is a structural schematic diagram of an acquisition circuit provided by an embodiment of the present invention, and as shown in FIG. 2, the acquisition circuit 300 comprises an acquisition pulse logic circuit 310 and a photoelectric isolation sampling circuit 320; the acquisition pulse logic circuit 310 comprises a control output terminal A, the first control terminal Con1, the second control terminal Con2 and the third control terminal Con3; the control output terminal A is electrically connected with a sampling control terminal A'; the first control terminal Con1 is electrically connected with the first output terminal Out1, the second control terminal Con2 is electrically connected with the second output terminal Out2, and the third control terminal Con3 is electrically connected with the third output terminal Out3; the acquisition pulse logic circuit 310 is used for outputting a sampling control signal to the photoelectric isolation sampling circuit 320 according to the first control signal, the second control signal, and the third control signal. The photoelectric isolation sampling circuit 320 comprises the sampling control terminal A', the positive input terminal +IN, the negative input terminal -IN, and the sampling output terminal B; the sampling control terminal A' is electrically connected with the control output terminal A; the positive input terminal +IN is electrically connected with the sampling terminal U; the sampling output terminal B is electrically connected with the first receiving terminal In1 and the second receiving terminal In2 respectively; the photoelectric isolation sampling circuit 320 is used for outputting the sampling signal to the first controller 310 and the second controller 320 according to the sampling control signal and the contact signal of the external relay collected at the acquisition terminal U.

Specifically, after the input first control signal, the input second control signal, and the input third control signal are logically processed, the acquisition pulse logic circuit 310 outputs a sampling control signal determined by the first control signal, the second control signal, and the third control signal, so that the sampling control signal is alternately correlated with the signals output by the first controller 100 and the second controller 200 in different periods. The first controller 100 outputs the dynamic code at time T, the second controller 200 outputs the dynamic code at time T+T1, and the first controller 100 and the second controller 200 alternately output the dynamic code. If the first controller 100 fails, the acquisition pulse logic circuit 310 outputs the corresponding sampling control signal according to the wrong first control signal. It is inconsistent with the corresponding sampling control signal output by the second controller 200 according to the second control signal and the third control signal, so that a single controller error does not cause a system error output. Further, after receiving the sampling control signal, the sampling control terminal A' of the photoelectric isolation sampling circuit 320 outputs the sampling signal according to the sampling control signal and the contact signal received by the positive input terminal +IN. Thus, by arranging the acquisition pulse logic circuit and the photoelectric isolation sampling circuit, the acquisition pulse logic circuit carries out logic processing on the input first control signal, the input second control signal and the input third control signal, and then outputs the unique determined sampling control signal to the photoelectric isolation sampling circuit. The structure of the acquisition pulse logic circuit can be arranged according to the actual demand, namely, the sampling control signal related to the first control signal, the second control signal and the third control signal can be output according to the actual demand, thereby realizing flexible control of the acquisition of the contact signal.

It is to be understood that the embodiments of the present invention can design the specific structures of the acquisition pulse logic circuit 310 and the photoelectric isolation sampling circuit 320 according to the actual needs, and the embodiments of the present invention does not limit the specific structures of the acquisition pulse logic circuit 310 and the photoelectric isolation sampling circuit 320 on the premise that the respective functions can be satisfied. The specific structures of the respective circuits of the embodiments of the present invention will be described in the following by way of typical examples.

Alternatively, FIG. 3 is a circuit schematic diagram of an acquisition pulse logic circuit provided by an embodiment of the present invention, and as shown in FIG. 3, the acquisition pulse logic circuit 310 further comprises an XOR gate SN1, an AND gate SN2, and a first resistance R1; a first terminal of the XOR gate SN1 is electrically connected with the second control terminal Con2; a second terminal of the XOR gate SN1 is electrically connected with the third control terminal Con3 through the first resistance R1; a first terminal of the AND gate SN2 is electrically connected with the first control terminal Con1; a second terminal of the AND gate SN2 is electrically connected with an output terminal of the XOR gate SN1, and an output terminal of the AND gate SN2 is electrically connected with the control output terminal A.

Wherein, the first resistance R1 divides the input third control signal and inputs it into the XOR gate SN1, so that the third control signal divided by the first resistance R1 can satisfy the normal operation requirement of the XOR gate SN1. It is understood that the output is a high level (e.g., denoted by a binary number "1") if the input levels at both ends of the XOR gate are different, a low level (e.g., denoted by a binary number "0") if the input levels at both ends of the XOR gate are the same, and, exemplarily, 0 if the inputs at both ends of the XOR gate are both 1 or 0; 1 If the inputs at both ends of the XOR gate are 1 and 0 respectively. If the input levels at both ends of the AND gate are 1, the output is 1, otherwise the output is 0, and, for example, if the inputs at both ends of the AND gate are 1, the output is 1; If the inputs at both ends of the AND gate are 1 and 0 respectively, the output is 0; If the input at both ends of the AND gate is 0, the output is 0.

Specifically, if the second control signal received by the second control terminal Con2 is a low level and the third control signal received by the third control terminal Con3 is a high level, the output terminal of the XOR gate SN1 output a high level, i.e., the second terminal of the AND gate SN2 receives a signal at a high level; at this time, if the first control signal received by the first control terminal Con1 is a high level, the output terminal of the AND gate SN2 outputs a high level to the control output terminal A. If the first control signal received by the first control terminal Con1 is a low level, the output terminal of the AND gate SN2 outputs a low level to the control output terminal A.

Correspondingly, if the second control signal received by the second control terminal Con2 is a high level, the third control signal received by the third control terminal Con3 is a low level, so that the output terminal of the XOR gate SN1 outputs a high level, i.e., the second terminal of the AND gate SN2 receives a signal of high level; at this time, if the first control signal received at the first control terminal Con1 is a high level, the output terminal of the AND gate SN2 outputs a high level to the control output terminal A. If the first control signal received by the first control terminal Con1 is a low level, the output terminal of the AND gate SN2 outputs a low level to the control output terminal A.

If the second control signal and the third control signal received by the second control terminal Con2 and the third control terminal Con3, respectively, are both a high level or both a low level, so that the output terminal of the XOR gate SN1 outputs a low level, i.e., the second terminal of the AND gate SN2 receives a signal of low level; at this time, if the first control signal received by the first control terminal Con1 is a high level, the output terminal of the AND gate SN2 outputs a low level to the control output terminal A. If the first control signal received by the first control terminal Con1 is a low level, the output terminal of the AND gate SN2 outputs a low level to the control output terminal A.

For example, taking one sampling period of 16ms as an example, the first sampling stage is the first 8ms, the first controller 100 acquires the sampling signal in the first stage, the second sampling stage is the last 8ms, and the second controller 200 acquires the sampling signal in the second stage. In the first sampling stage, the second control signal received by the second control terminal Con2 is a high level, and the third control signal received by the third control terminal Con3 is a low level, so that the output terminal of the XOR gate SN1 outputs a high level, i.e., the second terminal of the AND gate SN2 receives a signal of a high level; at this time, the level of the control output terminal A is the same as the first control signal received by the first control terminal Con1, i.e., if the first control signal received by the first control terminal Con1 is a high level, the output terminal of the AND gate SN2 outputs a high level to the control output terminal A, and if the first control signal received by the first control terminal Con1 is a low level, the output terminal of the AND gate SN2 outputs a low level to the control output terminal A.

In the second sampling stage, the first control signal received by the first control terminal Con1 is a high level, and the third control signal received by the third control terminal Con3 is a high level, at this time, the level of the control output terminal A is opposite to the level of the second control signal received by the second control terminal Con2, i.e., if the second control signal received by the second control terminal Con2 is a high level, the output terminal of the AND gate SN2 outputs a low level to the control output terminal A, if the second control signal received by the second control terminal Con2 is a low level, the output terminal of the AND gate SN2 outputs a high level to the control output terminal A. Therefore, in one sampling period, the first controller and the second controller output the control signal in stages and receive the sampling signal in stages, and the signals acquired by the first controller and the second controller are performed two selection operation, thereby avoiding output the erroneous sampling signal due to the failure of one of the controllers, improving the accuracy of the sampling signal output by the dynamic acquisition circuit, and thereby improving the safety.

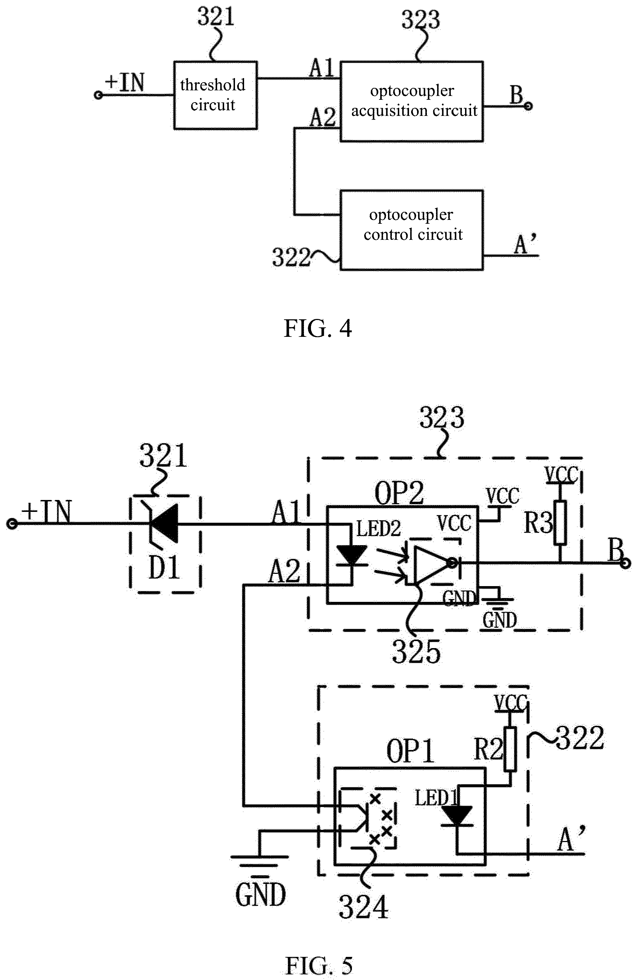

Alternatively, FIG. 4 is a structural schematic diagram of a photoelectric isolation sampling circuit provided by an embodiment of the present invention. As shown in FIG. 4, the photoelectric isolation sampling circuit 320 further comprises a threshold circuit 321, an optocoupler control circuit 322, and an optocoupler acquisition circuit 323. An input terminal of the threshold circuit 321 is electrically connected with the positive input terminal +IN, and an output terminal of the threshold circuit 321 is electrically connected with a first terminal A1 of the optocoupler acquisition circuit 323; the threshold circuit 321 is used for providing a first electrical signal to the optocoupler acquisition circuit 323 according to the contact signal. An input terminal of the optocoupler control circuit 322 is electrically connected with the sampling control terminal A', and an output terminal of the optocoupler control circuit 322 is electrically connected with a second terminal A2 of the optocoupler acquisition circuit 323; the optocoupler control circuit 322 is used for providing a second electrical signal to the optocoupler acquisition circuit 323 according to the sampling control signal; an output terminal of the optocoupler acquisition circuit 323 is electrically connected with the sampling output terminal B; the optocoupler acquisition circuit 323 is used for outputting the sampling signal according to the first electrical signal and the second electrical signal.

Specifically, the threshold circuit 321 is used for setting a threshold voltage, and exemplarily, the threshold voltage set by the threshold circuit 321 is 16 ~ 30V, and when the contact signal received by the threshold circuit 321 is within the threshold voltage range, the enable signal of the first electrical signal outputted by the threshold circuit 321 is used as the contact signal to control the potential of the first terminal A1 of the optocoupler acquisition circuit to be consistent with the contact signal. When the contact signal received by the threshold circuit 321 is not within the threshold voltage range, the non-enabling signal of the first electrical signal outputted by the threshold circuit 321 is used as the contact signal to control the potential of the first terminal A1 of the optocoupler acquisition circuit to be kept consistent with the contact signal at this time; wherein the enable signal of the first electrical signal may be a low level and the non-enabling signal of the first electrical signal may be a high level or a levitating state signal. Accordingly, after receiving the sampling control signal inputted from the sampling control terminal A', the optocoupler control circuit 322 outputs the second electrical signal to the second terminal of the optocoupler acquisition circuit 323 according to the sampling control signal; wherein, the second electrical signal can be set to a signal of a high level, a low level, or a levitating state according to a sampling demand.

In addition, the optocoupler acquisition circuit 323 may control the potential of the output sampling signal according to the magnitude or state of the potential of the first electrical signal and the second electrical signal inputted from the first terminal and the second terminal. In an exemplary embodiment, if the first electrical signal is greater than the second electrical signal, the output sample signal is a low level; if the first electrical signal is smaller than the second electrical signal, the output sampling signal is a high level. In this manner, the optocoupler acquisition circuit 323 can achieve the effect of accurately outputting the sampling signal according to the first electrical signal inputted from the threshold circuit 321 and the second electrical signal inputted from the optocoupler control circuit 322.

It is to be understood that the embodiments of the present invention can design the specific structures of the threshold circuit 321, the optocoupler control circuit 322, and the optocoupler acquisition circuit 323 according to the actual needs, and the embodiments of the present invention does not limit the specific structures of the threshold circuit 321, the optocoupler control circuit 322, and the optocoupler acquisition circuit 323 on the premise that the respective functions can be satisfied. The specific structures of the respective circuits of the embodiments of the present invention will be described in the following by way of typical examples.

Alternatively, FIG. 5 is a circuit schematic diagram of an photoelectric isolation sampling circuit provided by an embodiment of the present invention. As shown in FIG. 5, the optocoupler control circuit 322 comprises a first optocoupler switch OP1 and a second resistance R2; the first optocoupler switch OP1 comprises a first photosensitive element 324 and a first light emitting diode LED1; a first terminal of the second resistance R2 is electrically connected with a power supply VCC, a second terminal of the second resistance R2 is electrically connected with an anode of the first light emitting diode LED1, a cathode of the first light emitting diode LED1 is electrically connected with the sampling control terminal A'; a first terminal of the first photosensitive element 324 is electrically connected with a second terminal A2 of the optocoupler acquisition circuit 323, and a second terminal of the first photosensitive element 324 is grounded.

Wherein, the second resistance R2 divides the input power supply VCC and inputs it into the first light emitting diode LED1, so that the electrical signal divided by the second resistance R2 can meet the normal operation requirements of the first light emitting diode LED1.

Specifically, with reference to FIG. 3, when the second control signal and the third control signal output by the second controller 200 are both a low level or both a high level, the first control signal output by the first controller 100 is a high level, and the sampling control signal of high level is output according to the logic operation of the XOR gate SN1 and the AND gate SN2; the sampling control terminal A' receives the sampling control signal, the first light emitting diode LED1 is turned off in reverse and does not emit light, and the first photosensitive element 324 is not turned on and cannot transmit the electrical signal of the ground terminal GND to the second terminal A2 of the optocoupler acquisition circuit 323, and at this time, the optocoupler acquisition circuit 323 is not operated and cannot output the sampling signal.

Accordingly, when the second control signal and the third control signal outputted by the second controller 200 are a low level and a high level, respectively, the first control signal outputted by the first controller 100 is a low level, and the sampling control signal of low level is output according to the logic operation of the XOR gate SN1 and the AND gate SN2; after the sampling control terminal A' receives the sampling control signal, the first light emitting diode LED1 is turned on in the forward direction to emit light, and the first photosensitive element 324 is turned on to transmit the electrical signal of the ground terminal GND to the second terminal A2 of the optocoupler acquisition circuit 323, and at this time, if the first electrical signal output by the threshold circuit 321 is an enabling signal, the optocoupler acquisition circuit 323 will output a corresponding sampling signal. Thus, the second electrical signal output by the optocoupler control circuit is indirectly determined by the sampling control signal, thus having a good anti-interference effect.

Optionally, with reference to FIG. 5, the optocoupler acquisition circuit 323 comprises a second optocoupler switch OP2 and a third resistance R3; the second optocoupler switch OP2 comprises a second photosensitive element 325 and a second light emitting diode LED2; an anode of the second light emitting diode LED2 is electrically connected with the first terminal A1 of the optocoupler acquisition circuit 300, a cathode of the second light emitting diode LED2 is electrically connected with the second terminal A2 of the optocoupler acquisition circuit 300; a first terminal of the second photosensitive element 325 is electrically connected with the power supply VCC, a second terminal of the second photosensitive element 325 is electrically connected with the ground terminal GND, an output terminal of the second photosensitive element 325 is electrically connected with the sampling output terminal B; a first terminal of the third resistance R3 is electrically connected with the power supply VCC, and a second terminal of the third resistance R3 is coupled to an output terminal of the second photosensitive element 325.

Specifically, when the first electrical signal received by the first terminal A1 of the optocoupler acquisition circuit 323 is a high level and the second electrical signal received by the second terminal A2 is a low level, i.e., the first electrical signal is greater than the second electrical signal, and at this time, the second light emitting diode LED2 is turned on in the forward direction to emit light, and the second photosensitive element 325 is turned on to transmit the electrical signal of the ground terminal GND to the sampling output terminal B of the optocoupler acquisition circuit 323. Accordingly, when the first electrical signal received by the first terminal A1 of the optocoupler acquisition circuit 323 is smaller than the second electrical signal received by the second terminal A2, or the first terminal A1 and/or the second terminal A2 are a levitating state signal, and at this time the second light emitting diode LED3 is not turned on and does not emit light, the second photosensitive element 325 is not turned on, and the third resistance R3 pulls the sampling signal at the sampling output terminal B to be equal to the potential of the power supply VCC.

Combined with FIG. 3 and FIG. 5, when the contact signal of the external relay need to be acquired, the second control terminal Con2 and the third control terminal Con3 of the acquisition pulse logic circuit 310 respectively receive the second control signal of low level and the third control signal of high level, the XOR gate SN1 outputs a high level, the first control terminal Con1 receives the first control signal of low level, the AND gate SN2 outputs a low level to the control output terminal A, the sampling control terminal A' of the optocoupler control circuit 322 receives the sampling control signal of low level outputted from the control output terminal A, the first photosensitive element 324 is turned on after the first light emitting diode LED1 in the optocoupler control circuit 322 emits light, and transmits the electrical signal of the ground terminal GND to the second terminal A2 of the optocoupler acquisition circuit 323, at this time, if the contact of the external relay is closed and when the external acquisition voltage is within the threshold voltage range of the threshold circuit 321, the external acquisition voltage is transmitted to the first terminal of the optocoupler acquisition circuit 323 through the threshold circuit 321, the first electrical signal is the potential of the external acquisition voltage, the first electrical signal is larger than the second electrical signal, and after the second light emitting diode LED2 emits light, the second photosensitive element 325 is turned on, and the electrical signal of the ground terminal GND is transmitted to the sampling output terminal B. If the contact of the external relay are open, the contact signal received by the positive input terminal +IN of the acquisition circuit 300 is not within the threshold voltage range of the threshold circuit 321, the first terminal of the optocoupler acquisition circuit 323 is in a levitating state, the second light emitting diode LED2 does not emit light, then the second photosensitive element 325 is not turned on, and the third resistance R3 pulls the sampling signal at the sampling output B to be equal to the potential of the power supply VCC.

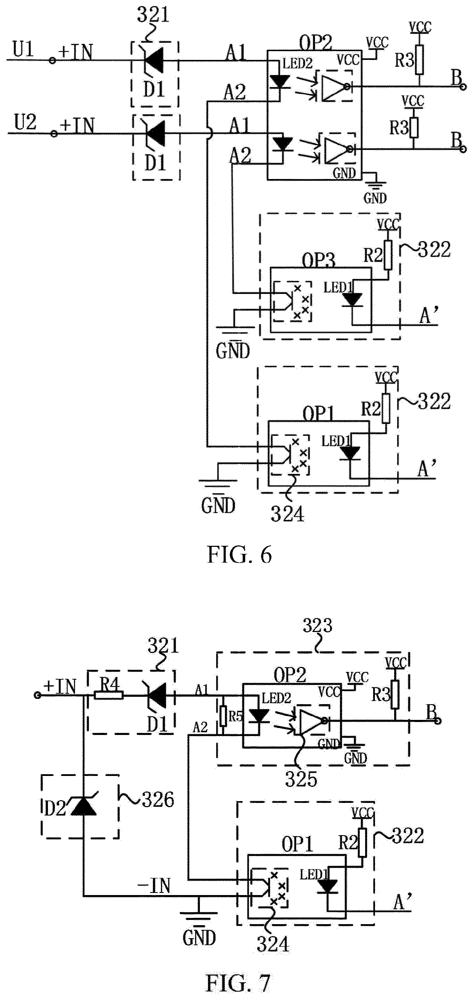

It is to be understood that the above-mentioned illustration has been given only by integrating the second optocoupler switch OP2 into one chip, and a plurality of second optocoupler switches OP2 can also be integrated into the same chip according to actual needs, thereby simplifying the circuit. FIG. 6 is a circuit schematic diagram of another photoelectric isolation sampling circuit provided by the embodiment of the present invention. As shown in FIG. 6, the circuit is simplified by integrating two second optocoupler switches comprised in the two optocoupler acquisition circuits 323 into the same chip, wherein the second optocoupler switch comprises a second photosensitive element, so that the first terminals of the two second photosensitive elements share a power supply terminal in the chip, and the second terminals of the two photosensitive elements share a ground terminal in the chip.

Optionally, with reference to FIG. 5, the threshold circuit 321 comprises a transient suppression diode D1; an anode of the transient suppression diode D1 is electrically connected with the first terminal A1 of the optocoupler acquisition circuit 323, and a cathode of the transient suppression diode D1 is electrically connected with the positive input terminal +IN.

Specifically, when the input contact signal is higher than the reverse breakdown voltage of the transient suppressing diode D1, the transient suppressing diode D1 is turned on in reverse, and transmits the input contact signal as a first electrical signal to the first terminal A1 of the optocoupler acquisition circuit 323. Accordingly, when the input contact signal is lower than the reverse breakdown voltage of the transient suppressing diode D1, the transient suppressing diode D1 is turned off in reverse, and cannot transmit the input contact signal as a first electrical signal to the first terminal A1 of the optocoupler acquisition circuit 323. It is to be understood that the reverse breakdown voltage of the transient suppressing diode D1 may be set according to practical requirements.

Optionally, FIG. 7 is a circuit schematic diagram of yet another photoelectric isolation sampling circuit provided by the embodiment of the present invention. As shown in FIG. 7, the photoelectric isolation sampling circuit 320 further comprises a protection circuit 326; a first terminal of the protection circuit 326 is electrically connected with the positive input terminal +IN, and a second terminal of the protection circuit 326 is electrically connected with the negative input terminal -IN. Therein, the protection circuit 326 may comprise, but is not limited to, a transient suppression diode D2 whose anode is electrically connected with the negative input terminal -IN and whose cathode is electrically connected with the positive input terminal +IN.

Specifically, the contact signal input from the positive input terminal +IN is higher than the threshold voltage value of the threshold circuit 321, i.e., the contact signal is higher than the reverse breakdown voltage of the transient suppression diode D2, and at this time, the contact signal is discharged through the cathode of the transient suppression diode D2 toward the ground connection GND without being transmitted to the following optocoupler acquisition circuit 323 through the threshold circuit 326, thus playing a role in protecting the optocoupler acquisition circuit 323.

In an optional embodiment, the optocoupler acquisition circuit 323 further comprises a fifth resistance R5, for when the first electrical signal is switched from the enabling electrical signal to the non-enabling electrical signal, the voltage across the second light emitting diode LED2 can be discharged through the fifth resistance R5, protecting the second light emitting diode LED2. The threshold circuit 321 also comprises a fourth resistance R4 for limiting the current flowing into the transient suppression diode D1.

Based on the same inventive concept, embodiments of the present invention also provide a transponder transmission system comprising a dynamic acquisition circuit provided by any one of the embodiments of the present invention, so it has the beneficial effect of the dynamic acquisition circuit, and the similarities refer to the above description.

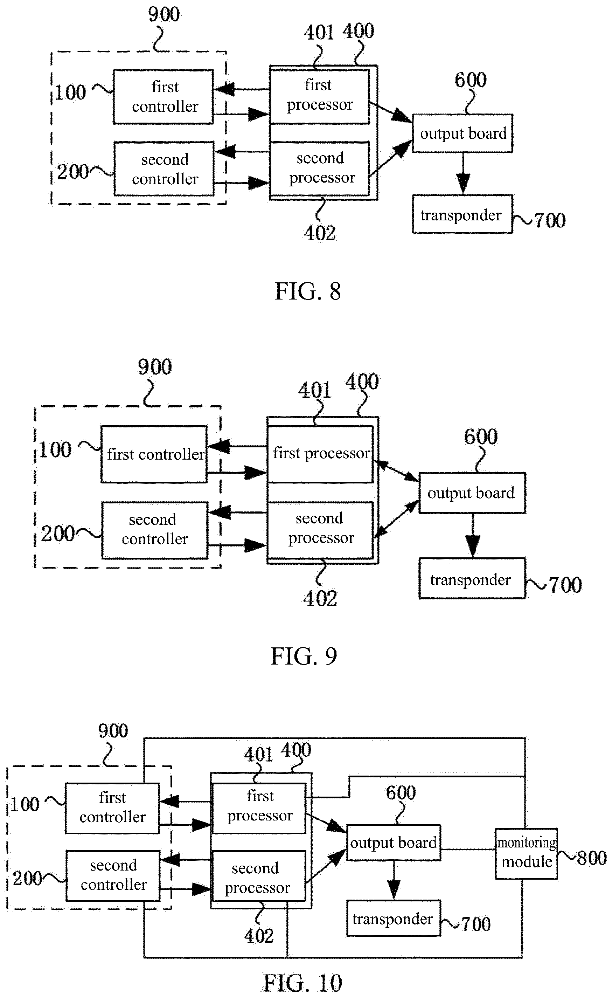

Alternatively, FIG. 8 is a structural schematic diagram of a transponder transmission system provided by the embodiment of the present invention. As shown in FIG. 8, the transponder transmission system comprises a processing board 400, an output board 600, a transponder 700, and a dynamic acquisition circuit 900 according to any embodiment of the present invention: the processing board 400 comprises a first processor 401 and a second processor 402, the first processor 401 is connected with the first controller 100 in the dynamic acquisition circuit 900; the first processor 401 is used for providing sampling command information to the first controller 100, receiving sampling information fed back by the first controller 100, and selecting an output message according to the sampling information fed back by the first controller 100. The second processor 402 is connected with the second controller 200 in the dynamic acquisition circuit 900; the second processor 402 is used for providing sampling command information to the second controller 200, receiving sampling information fed back by the second controller 200, and selecting an output message according to the sampling information fed back by the second controller 200. The first processor 401 and the second processor 402 take two selection operation and output the message to the output board 600. The output board 600 is used for providing, after encoding the message output by the first processor 401 and the second processor 402 though two selection operation, the encoded message to the transponder 700; the transponder 700 is used for outputting an electromagnetic signal according to the input encoded information.

Specifically, the first processor 401 provides sampling command information to the first controller 100, so that the first controller 100 inputs a first control signal to the dynamic acquisition circuit 900 according to the input sampling command information; the second processor 402 provides sampling command information to the second controller 200, so that the second controller 200 inputs the second control signal and the third control signal to the dynamic acquisition circuit 900 according to the input sampling command information; the dynamic acquisition circuit 900 feeds back accurate sampling signals to the first controller 100 and the second controller 200 according to the contact signal, the first control signal, the second control signal and the third control signal, so that the first processor 401 and the second processor 402 output corresponding message to the output board 600 by taking two selection operation according to the correct sampling signal; the output board 600 encodes the input message and provides the encoded message to the transponder 700 so that the transponder 700 outputs an electromagnetic signal according to the input encoded information.

Thus, by providing two processor in the processing board, each processor operating individually to receive sampling information fed back from the first controller and the second controller, respectively, i.e., using a two-out-of-two dynamic acquisition, the two processor do not interfere with each other and the accuracy of the signal transmitted by the transponder transmission system is improved.

Alternatively, FIG. 9 is a structural schematic diagram of another transponder transmission system provided by the embodiment of the present invention. As shown in FIG. 9, the output board 600 is further used for feeding back the output message to the processing board 400 as a feedback message. By comparing the feedback message with the output message, the current message output status can be confirmed to enable detection of the output board.

Alternatively, FIG. 10 is a structural schematic diagram of yet another transponder transmission system provided by the embodiment of the present invention. As shown in FIG. 10, the transponder transmission system further comprises: a monitoring module 800; the monitoring module 800 is electrically connected with the dynamic acquisition circuit 900, the processing board 400 and the output board 600, respectively, for recording running status information of the dynamic acquisition circuit 900, the processing board 400 and the output board 600. Among them, the running state information may include running parameter information and the like. So that the operation and maintenance personnel can maintain the dynamic acquisition circuit 900, the processing board 400, and the output board 600 according to the running status information recorded by the monitoring module 800, and keep the transponder transmission system working normally.

It should be understood that various forms of the flow shown above may be used, with steps reordered, added, or deleted. For example, each step described in the present invention may be executed in parallel, may be executed sequentially, or may be executed in a different order, which is not limited herein as long as the desired result of the technical solution of the present invention can be achieved.

## Claims

1. A dynamic acquisition circuit comprising:
a plurality of sampling terminals in corresponding electrical connection with a plurality of contacts of an external relay, wherein the sampling terminal is used for receiving a contact signal of the external relay;
a first controller and a second controller, wherein the first controller comprises a plurality of first output terminals and a plurality of first receiving terminals, the first output terminal is used for outputting a first control signal, the second controller comprises a plurality of second output terminals, a plurality of third output terminals, and a plurality of second receiving terminals, the second output terminal is used for outputting a second control signal, and the third output terminal is used for outputting a third control signal;
a plurality of acquisition circuits, a positive input terminal of each of the acquisition circuits being electrically connected with each of the sampling terminals in one-to-one correspondence respectively, a negative input terminal of each of the acquisition circuits being grounded, a first control terminal of each of the acquisition circuits being electrically connected with each of the first output terminals in one-to-one correspondence respectively, a second control terminal of each of the acquisition circuits being electrically connected with each of the second output terminals in one-to-one correspondence respectively, a third control terminal of each of the acquisition circuits being electrically connected with each of the third output terminals in one-to-one correspondence respectively, a sampling output terminal of each of the acquisition circuits being electrically connected with each of the first receiving terminals in one-to-one correspondence respectively, a sampling output terminals of each of the acquisition circuits being also electrically connected with each of the second receiving terminals in one-to-one correspondence respectively; the acquisition circuit is used for providing a sampling signal to the first controller and the second controller, respectively, according to the contact signal, the first control signal, the second control signal, and the third control signal.

2. The dynamic acquisition circuit of claim 1, **characterized in that** the acquisition circuit comprises an acquisition pulse logic circuit and a photoelectric isolation sampling circuit;
the acquisition pulse logic circuit comprises a control output terminal, the first control terminal, the second control terminal and the third control terminal; the control output terminal is electrically connected with a sampling control terminal; the first control terminal is electrically connected with the first output terminal, the second control terminal is electrically connected with the second output terminal, and the third control terminal is electrically connected with the third output terminal; the acquisition pulse logic circuit is used for outputting a sampling control signal to the photoelectric isolation sampling circuit according to the first control signal, the second control signal, and the third control signal;
the photoelectric isolation sampling circuit comprises the sampling control terminal, the positive input terminal, the negative input terminal, and the sampling output terminal; the sampling control terminal is electrically connected with the control output terminal; the positive input terminal is electrically connected with the sampling terminal; the sampling output terminal is electrically connected with the first receiving terminal and the second receiving terminal respectively; the photoelectric isolation sampling circuit is used for outputting the sampling signal to the first controller and the second controller according to the sampling control signal and the contact signal of the external relay acquired at the acquisition terminal.

3. The dynamic acquisition circuit of claim 2, **characterized in that** the acquisition pulse logic circuit further comprises an XOR gate, an AND gate, and a first resistance;
a first terminal of the XOR gate is electrically connected with the second control terminal; a second terminal of the XOR gate is electrically connected with the third control terminal through the first resistance;
a first terminal of the AND gate is electrically connected with the first control terminal; a second terminal of the AND gate is electrically connected with an output terminal of the XOR gate, and an output terminal of the AND gate is electrically connected with the control output terminal.

4. The dynamic acquisition circuit of claim 2, **characterized in that** the photoelectric isolation sampling circuit further comprises a threshold circuit, an optocoupler control circuit, an optocoupler acquisition circuit;
an input terminal of the threshold circuit is electrically connected with the positive input terminal, and an output terminal of the threshold circuit is electrically connected with a first terminal of the optocoupler acquisition circuit; the threshold circuit is used for providing a first electrical signal to the optocoupler acquisition circuit according to the contact signal;
an input terminal of the optocoupler control circuit is electrically connected with the sampling control terminal, and an output terminal of the optocoupler control circuit is electrically connected with a second terminal of the optocoupler acquisition circuit; the optocoupler control circuit is used for providing a second electrical signal to the optocoupler acquisition circuit according to the sampling control signal;
an output terminal of the optocoupler acquisition circuit is electrically connected with the sampling output terminal; the optocoupler acquisition circuit is used for outputting the sampling signal according to the first electrical signal and the second electrical signal.

5. The dynamic acquisition circuit of claim 4, **characterized in that** the optocoupler control circuit comprises a first optocoupler switch and a second resistance;
the first optocoupler switch comprises a first photosensitive element and a first light emitting diode;
a first terminal of the second resistance is electrically connected with a power supply, a second terminal of the second resistance is electrically connected with an anode of the first light emitting diode, a cathode of the first light emitting diode is electrically connected with the sampling control terminal;
a first terminal of the first photosensitive element is electrically connected with the second terminal of the optocoupler acquisition circuit, and the second terminal of the first photosensitive element is grounded.

6. The dynamic acquisition circuit according to claim 4, **characterized in that** the optocoupler acquisition circuit comprises a second optocoupler switch and a third resistance;
the second optocoupler switch comprises a second photosensitive element and a second light emitting diode;
an anode of the second light emitting diode is electrically connected with the first terminal of the optocoupler acquisition circuit, a cathode of the second light emitting diode is electrically connected with the second terminal of the optocoupler acquisition circuit;
a first terminal of the second photosensitive element is electrically connected with a power supply, a second terminal of the second photosensitive element is electrically connected with a ground terminal, an output terminal of the second photosensitive element is electrically connected with the sampling output terminal;
a first terminal of the third resistance is electrically connected with the power supply, and a second terminal of the third resistance is coupled to an output terminal of the second photosensitive element.

7. The dynamic acquisition circuit of claim 4, **characterized in that** the threshold circuit comprises a transient suppression diode;
an anode of the transient suppression diode is electrically connected with the first terminal of the optocoupler acquisition circuit, and a cathode of the transient suppression diode is electrically connected with the positive input terminal.

8. The dynamic acquisition circuit of claim 4, **characterized in that** the photoelectric isolation sampling circuit further comprises a protection circuit;
a first terminal of the protection circuit is electrically connected with the positive input terminal, and a second terminal of the protection circuit is electrically connected with the negative input terminal.

9. A transponder transmission system, **characterized in that** the transponder transmission system comprises: a processing board, an output board, a transponder, and the dynamic acquisition circuit of any of claims 1-8: the processing board comprises a first processor and a second processor;
the first processor is connected with the first controller in the dynamic acquisition circuit; the first processor is used for providing sampling command information to the first controller, receiving sampling information fed back by the first controller, and selecting an output message according to the sampling information fed back by the first controller;
the second processor is connected with the second controller in the dynamic acquisition circuit; the second processor is used for providing sampling command information to the second controller, receiving sampling information fed back by the second controller, and selecting an output message according to the sampling information fed back by the second controller;
the output board is electrically connected with the processing board and the transponder, respectively; the output board is used for providing, after encoding the message output by the processing board, the encoded message to the transponder;
the transponder is used for outputting an electromagnetic signal according to the input encoded information.

10. The transponder transmission system of claim 9, **characterized in that**
the output board is further used for feeding back the output message to the processing board as a feedback message;
the processing board is further used for comparing the feedback message with the message output by the processing board, and determining a current message output status of the output board according to the comparison.

11. The transponder transmission system of claim 9, **characterized in** further comprising a monitoring module;
the monitoring module is electrically connected with the dynamic acquisition circuit, the processing board and the output board respectively; the monitoring module is used for recording running status information of the dynamic acquisition circuit, the processing board and the output board.

## Patentansprüche

1. Dynamische Erfassungsschaltung, umfassend:
eine Vielzahl von Abtastanschlüssen in entsprechender elektrischer Verbindung mit einer Vielzahl von Kontakten eines externen Relais, wobei der Abtastanschluss zum Empfangen eines Kontaktsignals des externen Relais verwendet wird;
eine erste Steuerung und eine zweite Steuerung, wobei die erste Steuerung eine Vielzahl von ersten Ausgangsanschlüssen und eine Vielzahl von ersten Empfangsanschlüssen umfasst, der erste Ausgangsanschluss zum Ausgeben eines ersten Steuersignals verwendet wird, die zweite Steuerung eine Vielzahl von zweiten Ausgangsanschlüssen, eine Vielzahl von dritten Ausgangsanschlüssen und eine Vielzahl von zweiten Empfangsanschlüssen umfasst, der zweite Ausgangsanschluss zum Ausgeben eines zweiten Steuersignals verwendet wird und der dritte Ausgangsanschluss zum Ausgeben eines dritten Steuersignals verwendet wird;
eine Vielzahl von Erfassungsschaltungen, wobei ein positiver Eingangsanschluss jeder der Erfassungsschaltungen jeweils mit jedem der Abtastanschlüsse in Eins-zu-Eins-Entsprechung elektrisch verbunden ist, ein negativer Eingangsanschluss jeder der Erfassungsschaltungen geerdet ist, ein erster Steueranschluss jeder der Erfassungsschaltungen jeweils mit jedem der ersten Ausgangsanschlüsse in Eins-zu-Eins-Entsprechung elektrisch verbunden ist, ein zweiter Steueranschluss jeder der Erfassungsschaltungen jeweils mit jedem der zweiten Ausgangsanschlüsse in Eins-zu-Eins-Entsprechung elektrisch verbunden ist, ein dritter Steueranschluss jeder der Erfassungsschaltungen jeweils mit jedem der dritten Ausgangsanschlüsse in Eins-zu-Eins-Entsprechung elektrisch verbunden ist, ein Abtastausgangsanschluss jeder der Erfassungsschaltungen jeweils mit jedem der ersten Empfangsanschlüsse in Eins-zu-Eins-Entsprechung elektrisch verbunden ist, ein Abtastausgangsanschluss jeder der Erfassungsschaltungen auch jeweils mit jedem der zweiten Empfangsanschlüsse in Eins-zu-Eins-Entsprechung elektrisch verbunden ist; die Erfassungsschaltung zum Bereitstellen eines Abtastsignals für die erste Steuerung beziehungsweise die zweite Steuerung gemäß dem Kontaktsignal, dem ersten Steuersignal, dem zweiten Steuersignal und dem dritten Steuersignal verwendet wird.

2. Dynamische Erfassungsschaltung nach Anspruch 1, **dadurch gekennzeichnet, dass** die Erfassungsschaltung eine Erfassungsimpulslogikschaltung und eine photoelektrische Isolationsabtastschaltung umfasst;
die Erfassungsimpulslogikschaltung einen Steuerausgangsanschluss, den ersten Steueranschluss, den zweiten Steueranschluss und den dritten Steueranschluss umfasst; der Steuerausgangsanschluss elektrisch mit einem Abtaststeueranschluss verbunden ist; der erste Steueranschluss elektrisch mit dem ersten Ausgangsanschluss verbunden ist, der zweite Steueranschluss elektrisch mit dem zweiten Ausgangsanschluss verbunden ist und der dritte Steueranschluss elektrisch mit dem dritten Ausgangsanschluss verbunden ist; die Erfassungsimpulslogikschaltung zum Ausgeben eines Abtaststeuersignals an die photoelektrische Isolationsabtastschaltung gemäß dem ersten Steuersignal, dem zweiten Steuersignal und dem dritten Steuersignal verwendet wird;
die photoelektrische Isolationsabtastschaltung den Abtaststeueranschluss, den positiven Eingangsanschluss, den negativen Eingangsanschluss und den Abtastausgangsanschluss umfasst; der Abtaststeueranschluss elektrisch mit dem Steuerausgangsanschluss verbunden ist; der positive Eingangsanschluss elektrisch mit dem Abtastanschluss verbunden ist; der Abtastausgangsanschluss elektrisch mit dem ersten Empfangsanschluss beziehungsweise dem zweiten Empfangsanschluss verbunden ist; die photoelektrische Isolationsabtastschaltung zum Ausgeben des Abtastsignals an die erste Steuerung und die zweite Steuerung gemäß dem Abtaststeuersignal und dem Kontaktsignal des an dem Erfassungsanschluss erfassten externen Relais verwendet wird.

3. Dynamische Erfassungsschaltung nach Anspruch 2, **dadurch gekennzeichnet, dass** die Erfassungsimpulslogikschaltung ferner ein XOR-Gatter, ein UND-Gatter und einen ersten Widerstand umfasst;
ein erster Anschluss des XOR-Gatters elektrisch mit dem zweiten Steueranschluss verbunden ist; ein zweiter Anschluss des XOR-Gatters über den ersten Widerstand elektrisch mit dem dritten Steueranschluss verbunden ist;
ein erster Anschluss des UND-Gatters elektrisch mit dem ersten Steueranschluss verbunden ist; ein zweiter Anschluss des UND-Gatters elektrisch mit einem Ausgangsanschluss des XOR-Gatters verbunden ist und ein Ausgangsanschluss des UND-Gatters elektrisch mit dem Steuerausgangsanschluss verbunden ist.

4. Dynamische Erfassungsschaltung nach Anspruch 2, **dadurch gekennzeichnet, dass** die photoelektrische Isolationsabtastschaltung ferner eine Schwellenschaltung, eine Optokopplersteuerschaltung und eine Optokopplererfassungsschaltung umfasst;
ein Eingangsanschluss der Schwellenschaltung elektrisch mit dem positiven Eingangsanschluss verbunden ist und ein Ausgangsanschluss der Schwellenschaltung elektrisch mit einem ersten Anschluss der Optokopplererfassungsschaltung verbunden ist; die Schwellenschaltung zum Bereitstellen eines ersten elektrischen Signals an die Optokopplererfassungsschaltung gemäß dem Kontaktsignal verwendet wird;
ein Eingangsanschluss der Optokopplersteuerschaltung elektrisch mit dem Abtaststeueranschluss verbunden ist und ein Ausgangsanschluss der Optokopplersteuerschaltung elektrisch mit einem zweiten Anschluss der Optokopplererfassungsschaltung verbunden ist; die Optokopplersteuerschaltung zum Bereitstellen eines zweiten elektrischen Signals an die Optokopplererfassungsschaltung gemäß dem Abtaststeuersignal verwendet wird;
ein Ausgangsanschluss der Optokopplererfassungsschaltung elektrisch mit dem Abtastausgangsanschluss verbunden ist; die Optokopplererfassungsschaltung zum Ausgeben des Abtastsignals gemäß dem ersten elektrischen Signal und dem zweiten elektrischen Signal verwendet wird.

5. Dynamische Erfassungsschaltung nach Anspruch 4, **dadurch gekennzeichnet, dass** die Optokopplersteuerschaltung einen ersten Optokopplerschalter und einen zweiten Widerstand umfasst; der erste Optokopplerschalter ein erstes photosensitives Element und eine erste lichtemittierende Diode umfasst;
ein erster Anschluss des zweiten Widerstands elektrisch mit einer Stromversorgung verbunden ist, ein zweiter Anschluss des zweiten Widerstands elektrisch mit einer Anode der ersten lichtemittierenden Diode verbunden ist, eine Kathode der ersten lichtemittierenden Diode elektrisch mit dem Abtaststeueranschluss verbunden ist;
ein erster Anschluss des ersten photosensitiven Elements elektrisch mit dem zweiten Anschluss der Optokopplererfassungsschaltung verbunden ist und der zweite Anschluss des ersten photosensitiven Elements geerdet ist.

6. Dynamische Erfassungsschaltung nach Anspruch 4, **dadurch gekennzeichnet, dass** die Optokopplererfassungsschaltung einen zweiten Optokopplerschalter und einen dritten Widerstand umfasst;
der zweite Optokopplerschalter ein zweites photosensitives Element und eine zweite lichtemittierende Diode umfasst;
eine Anode der zweiten lichtemittierenden Diode elektrisch mit dem ersten Anschluss der Optokopplererfassungsschaltung verbunden ist, eine Kathode der zweiten lichtemittierenden Diode elektrisch mit dem zweiten Anschluss der Optokopplererfassungsschaltung verbunden ist;
ein erster Anschluss des zweiten photosensitiven Elements elektrisch mit einer Stromversorgung verbunden ist, ein zweiter Anschluss des zweiten photosensitiven Elements elektrisch mit einem Erdungsanschluss verbunden ist, ein Ausgangsanschluss des zweiten photosensitiven Elements elektrisch mit dem Abtastausgangsanschluss verbunden ist;
ein erster Anschluss des dritten Widerstands elektrisch mit der Stromversorgung verbunden ist und ein zweiter Anschluss des dritten Widerstands mit einem Ausgangsanschluss des zweiten photosensitiven Elements gekoppelt ist.

7. Dynamische Erfassungsschaltung nach Anspruch 4, **dadurch gekennzeichnet, dass** die Schwellenschaltung eine Transientenunterdrückungsdiode umfasst;
eine Anode der Transientenunterdrückungsdiode elektrisch mit dem ersten Anschluss der Optokopplererfassungsschaltung verbunden ist und eine Kathode der Transientenunterdrückungsdiode elektrisch mit dem positiven Eingangsanschluss verbunden ist.

8. Dynamische Erfassungsschaltung nach Anspruch 4, **dadurch gekennzeichnet, dass** die photoelektrische Isolationsabtastschaltung ferner eine Schutzschaltung umfasst;
ein erster Anschluss der Schutzschaltung elektrisch mit dem positiven Eingangsanschluss verbunden ist und ein zweiter Anschluss der Schutzschaltung elektrisch mit dem negativen Eingangsanschluss verbunden ist.

9. Transponderübertragungssystem, **dadurch gekennzeichnet, dass** das Transponderübertragungssystem Folgendes umfasst: eine Verarbeitungsplatine, eine Ausgabeplatine, einen Transponder und die dynamische Erfassungsschaltung nach einem der Ansprüche 1 bis 8: die Verarbeitungsplatine einen ersten Prozessor und einen zweiten Prozessor umfasst;
der erste Prozessor mit der ersten Steuerung in der dynamischen Erfassungsschaltung verbunden ist; der erste Prozessor zum Bereitstellen von Abtastbefehlsinformationen für die erste Steuerung, Empfangen von von der ersten Steuerung rückgemeldeten Abtastinformationen und Auswählen einer Ausgabenachricht gemäß den von der ersten Steuerung rückgemeldeten Abtastinformationen verwendet wird;
der zweite Prozessor mit der zweite Steuerung in der dynamischen Erfassungsschaltung verbunden ist; der zweite Prozessor zum Bereitstellen von Abtastbefehlsinformationen für die zweite Steuerung, Empfangen von von der zweiten Steuerung rückgemeldeten Abtastinformationen, und Auswählen einer Ausgabenachricht gemäß den von der zweiten Steuerung rückgemeldeten Abtastinformationen verwendet wird;
die Ausgabeplatine elektrisch mit der Verarbeitungsplatine beziehungsweise dem Transponder verbunden ist; die Ausgabeplatine nach dem Codieren der von der Verarbeitungsplatine ausgegebenen Nachricht zum Bereitstellen der codierten Nachricht für den Transponder verwendet wird;
der Transponder zum Ausgeben eines elektromagnetischen Signals gemäß den eingegebenen codierten Informationen verwendet wird.

10. Transponderübertragungssystem nach Anspruch 9, **dadurch gekennzeichnet, dass**
die Ausgangsplatine ferner zum Rückmelden der Ausgangsnachricht als eine Rückmeldenachricht an die Verarbeitungsplatine verwendet wird;
die Verarbeitungsplatine ferner zum Vergleichen der Rückmeldenachricht mit der von der Verarbeitungsplatine ausgegebenen Nachricht und Bestimmen eines aktuellen Nachrichtenausgabestatus der Ausgabeplatine gemäß dem Vergleich verwendet wird.

11. Transponderübertragungssystem nach Anspruch 9, **dadurch gekennzeichnet, dass** es ferner ein Überwachungsmodul umfasst;
das Überwachungsmodul elektrisch mit der dynamischen Erfassungsschaltung, der Verarbeitungsplatine beziehungsweise der Ausgabeplatine verbunden ist; das Überwachungsmodul zum Aufzeichnen von Betriebsstatusinformationen der dynamischen Erfassungsschaltung, der Verarbeitungsplatine und der Ausgabeplatine verwendet wird.

## Revendications

1. Circuit d'acquisition dynamique comprenant :
une pluralité de bornes d'échantillonnage en connexion électrique correspondante avec une pluralité de contacts d'un relais externe, dans lequel la borne d'échantillonnage est utilisée pour recevoir un signal de contact du relais externe ;
un premier dispositif de commande et un second dispositif de commande, dans lequel le premier dispositif de commande comprend une pluralité de premières bornes de sortie et une pluralité de premières bornes de réception, la première borne de sortie est utilisée pour émettre un premier signal de commande, le second dispositif de commande comprend une pluralité de deuxièmes bornes de sortie, une pluralité de troisièmes bornes de sortie et une pluralité de secondes bornes de réception, la deuxième borne de sortie est utilisée pour émettre un deuxième signal de commande et la troisième borne de sortie est utilisée pour émettre un troisième signal de commande ;
une pluralité de circuits d'acquisition, une borne d'entrée positive de chacun des circuits d'acquisition étant connectée électriquement à chacune des bornes d'échantillonnage en correspondance biunivoque, une borne d'entrée négative de chacun des circuits d'acquisition étant mise à la terre, une première borne de commande de chacun des circuits d'acquisition étant connectée électriquement à chacune des premières bornes de sortie en correspondance biunivoque respectivement, une deuxième borne de commande de chacun des circuits d'acquisition étant connectée électriquement à chacune des deuxièmes bornes de sortie en correspondance biunivoque respectivement, une troisième borne de commande de chacun des circuits d'acquisition étant connectée électriquement à chacune des troisièmes bornes de sortie en correspondance biunivoque respectivement, une borne de sortie d'échantillonnage de chacun des circuits d'acquisition étant connectée électriquement à chacune des premières bornes de réception en correspondance biunivoque respectivement, les bornes de sortie d'échantillonnage de chacun des circuits d'acquisition étant également connectées électriquement à chacune des secondes bornes de réception en correspondance biunivoque respectivement ; le circuit d'acquisition est utilisé pour fournir un signal d'échantillonnage au premier dispositif de commande et au second dispositif de commande, respectivement, en fonction du signal de contact, du premier signal de commande, du deuxième signal de commande et du troisième signal de commande.

2. Circuit d'acquisition dynamique selon la revendication 1, **caractérisé en ce que** le circuit d'acquisition comprend un circuit logique d'impulsions d'acquisition et un circuit d'échantillonnage à isolation photoélectrique ;
le circuit logique d'impulsions d'acquisition comprend une borne de sortie de commande, la première borne de commande, la deuxième borne de commande et la troisième borne de commande ; la borne de sortie de commande est connectée électriquement à une borne de commande d'échantillonnage ; la première borne de commande est connectée électriquement à la première borne de sortie, la deuxième borne de commande est connectée électriquement à la deuxième borne de sortie et la troisième borne de commande est connectée électriquement à la troisième borne de sortie ; le circuit logique d'impulsions d'acquisition est utilisé pour émettre un signal de commande d'échantillonnage vers le circuit d'échantillonnage à isolation photoélectrique en fonction du premier signal de commande, du deuxième signal de commande et du troisième signal de commande ;
le circuit d'échantillonnage à isolation photoélectrique comprend la borne de commande d'échantillonnage, la borne d'entrée positive, la borne d'entrée négative et la borne de sortie d'échantillonnage ; la borne de commande d'échantillonnage est connectée électriquement à la borne de sortie de commande ; la borne d'entrée positive est connectée électriquement à la borne d'échantillonnage ; la borne de sortie d'échantillonnage est connectée électriquement à la première borne de réception et à la seconde borne de réception, respectivement ; le circuit d'échantillonnage à isolation photoélectrique est utilisé pour émettre le signal d'échantillonnage vers le premier dispositif de commande et le second dispositif de commande en fonction du signal de commande d'échantillonnage et du signal de contact du relais externe acquis à la borne d'acquisition.

3. Circuit d'acquisition dynamique selon la revendication 2, **caractérisé en ce que** le circuit logique d'impulsions d'acquisition comprend en outre une porte XOR, une porte AND et une première résistance ;
une première borne de la porte XOR est connectée électriquement à la deuxième borne de commande ; une seconde borne de la porte XOR est connectée électriquement à la troisième borne de commande via la première résistance ;
une première borne de la porte AND est connectée électriquement à la première borne de commande ; une seconde borne de la porte AND est connectée électriquement à une borne de sortie de la porte XOR, et une borne de sortie de la porte AND est connectée électriquement à la borne de sortie de commande.

4. Circuit d'acquisition dynamique selon la revendication 2, **caractérisé en ce que** le circuit d'échantillonnage à isolation photoélectrique comprend en outre un circuit de seuil, un circuit de commande d'optocoupleur, un circuit d'acquisition d'optocoupleur ;
une borne d'entrée du circuit de seuil est connectée électriquement à la borne d'entrée positive, et une borne de sortie du circuit de seuil est connectée électriquement à une première borne du circuit d'acquisition d'optocoupleur ; le circuit de seuil est utilisé pour fournir un premier signal électrique au circuit d'acquisition d'optocoupleur en fonction du signal de contact ;
une borne d'entrée du circuit de commande d'optocoupleur est connectée électriquement à la borne de commande d'échantillonnage, et une borne de sortie du circuit de commande d'optocoupleur est connectée électriquement à une seconde borne du circuit d'acquisition d'optocoupleur ; le circuit de commande d'optocoupleur est utilisé pour fournir un second signal électrique au circuit d'acquisition d'optocoupleur en fonction du signal de commande d'échantillonnage ;
une borne de sortie du circuit d'acquisition d'optocoupleur est connectée électriquement à la borne de sortie d'échantillonnage ; le circuit d'acquisition d'optocoupleur est utilisé pour émettre le signal d'échantillonnage en fonction du premier signal électrique et du second signal électrique.

5. Circuit d'acquisition dynamique selon la revendication 4, **caractérisé en ce que** le circuit de commande d'optocoupleur comprend un premier commutateur d'optocoupleur et une deuxième résistance ;
le premier commutateur d'optocoupleur comprend un premier élément photosensible et une première diode électroluminescente ;
une première borne de la deuxième résistance est connectée électriquement à une alimentation, une seconde borne de la deuxième résistance est connectée électriquement à une anode de la première diode électroluminescente, une cathode de la première diode électroluminescente est connectée électriquement à la borne de commande d'échantillonnage ;
une première borne du premier élément photosensible est connectée électriquement à la seconde borne du circuit d'acquisition d'optocoupleur, et la seconde borne du premier élément photosensible est mise à la terre.

6. Circuit d'acquisition dynamique selon la revendication 4, **caractérisé en ce que** le circuit d'acquisition d'optocoupleur comprend un second commutateur d'optocoupleur et une troisième résistance ;
le second commutateur d'optocoupleur comprend un second élément photosensible et une seconde diode électroluminescente ;
une anode de la seconde diode électroluminescente est connectée électriquement à la première borne du circuit d'acquisition d'optocoupleur, une cathode de la seconde diode électroluminescente est connectée électriquement à la seconde borne du circuit d'acquisition d'optocoupleur ;
une première borne du second élément photosensible est connectée électriquement à une alimentation, une seconde borne du second élément photosensible est connectée électriquement à une borne de masse, une borne de sortie du second élément photosensible est connectée électriquement à la borne de sortie d'échantillonnage ;
une première borne de la troisième résistance est connectée électriquement à l'alimentation, et une seconde borne de la troisième résistance est couplée à une borne de sortie du second élément photosensible.

7. Circuit d'acquisition dynamique selon la revendication 4, **caractérisé en ce que** le circuit de seuil comprend une diode de suppression des transitoires ;
une anode de la diode de suppression des transitoires est connectée électriquement à la première borne du circuit d'acquisition d'optocoupleur, et une cathode de la diode de suppression des transitoires est connectée électriquement à la borne d'entrée positive.

8. Circuit d'acquisition dynamique selon la revendication 4, **caractérisé en ce que** le circuit d'échantillonnage à isolation photoélectrique comprend en outre un circuit de protection ;
une première borne du circuit de protection est connectée électriquement à la borne d'entrée positive, et une seconde borne du circuit de protection est connectée électriquement à la borne d'entrée négative.

9. Système de transmission par transpondeur, **caractérisé en ce que** le système de transmission par transpondeur comprend : une carte de traitement, une carte de sortie, un transpondeur et le circuit d'acquisition dynamique selon l'une quelconque des revendications 1 à 8 : la carte de traitement comprend un premier processeur et un second processeur ;
le premier processeur est connecté au premier dispositif de commande dans le circuit d'acquisition dynamique ; le premier processeur est utilisé pour fournir des informations de commande d'échantillonnage au premier dispositif de commande, recevoir des informations d'échantillonnage renvoyées par le premier dispositif de commande et sélectionner un message de sortie en fonction des informations d'échantillonnage renvoyées par le premier dispositif de commande ;
le second processeur est connecté au second dispositif de commande dans le circuit d'acquisition dynamique ; le second processeur est utilisé pour fournir des informations de commande d'échantillonnage au second dispositif de commande, recevoir des informations d'échantillonnage renvoyées par le second dispositif de commande et sélectionner un message de sortie en fonction des informations d'échantillonnage renvoyées par le second dispositif de commande ;
la carte de sortie est connectée électriquement à la carte de traitement et au transpondeur, respectivement ; la carte de sortie est utilisée pour fournir, après encodage du message émis par la carte de traitement, le message encodé au transpondeur ;
le transpondeur est utilisé pour émettre un signal électromagnétique en fonction des informations codées en entrée.

10. Système de transmission par transpondeur selon la revendication 9, **caractérisé en ce que**
la carte de sortie est en outre utilisée pour renvoyer le message de sortie à la carte de traitement sous forme de message de retour ;
la carte de traitement est en outre utilisée pour comparer le message de retour avec le message fourni par la carte de traitement, et pour déterminer l'état actuel de la sortie de message de la carte de sortie en fonction de la comparaison.

11. Système de transmission par transpondeur selon la revendication 9, **caractérisé en ce qu'**il comprend en outre un module de surveillance ;
le module de surveillance est connecté électriquement au circuit d'acquisition dynamique, à la carte de traitement et à la carte de sortie respectivement ; le module de surveillance est utilisé pour enregistrer des informations d'état de fonctionnement du circuit d'acquisition dynamique, de la carte de traitement et de la carte de sortie.
